# EUROPEAN PATENT SPECIFICATION

(11) **EP 1 286 467 B1**
(45) Date of publication and mention of the grant of the patent: **27.10.2004**
(21) Application number: 01307137.8
(22) Date of filing: 22.08.2001
(51) Int. Cl.: H03K 5/06, H03K 5/13

(54) **A method of and apparatus for modifying the profile of a pulse**
Verfahren und Vorrichtung zum Ändern des Profils eines Pulses
Procédé et appareil pour modifier le profile d'une impulsion

(43) Date of publication of application: 26.02.2003
(73) Proprietor: Infineon Technologies AG, 81669 München (DE)
(72) Inventor: Ma, Fan Yung, Singapore 359235 (SG)
(74) Representative: Watkin, Timothy Lawrence Harvey

(56) References cited:
- US-A- 4 675 546
- US-A- 4 719 365
- US-A- 4 961 013
- US-A- 5 180 937

## Description

The invention relates to a method of and apparatus for modifying the profile of a pulse and in particular, by modifying the width (or duration) of the pulse.

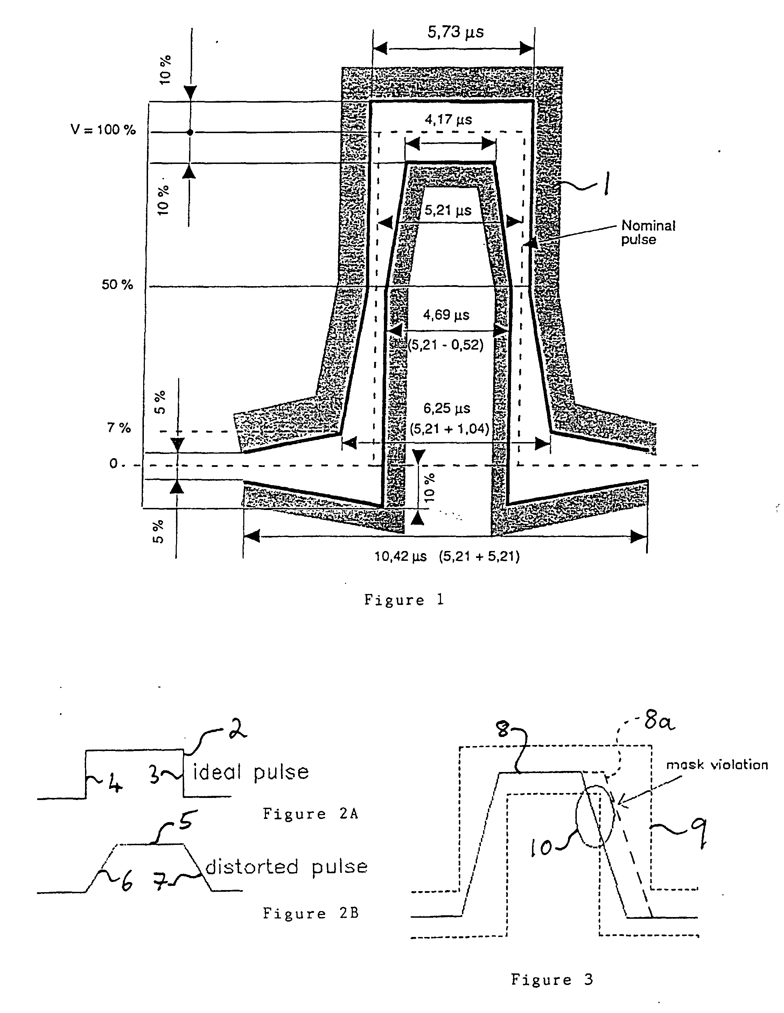

In digital telecommunication applications, it can be necessary for a pulse in a digital data signal to comply with standard pulse mask shapes. For example, in the European Telecommunication Standard (ETSI) for ISDN communications, any pulse in the digital signal emitted by a transmitter must fall within the mask 1 shown in Figure 1. This mask shape is provided for in ETSI prETS300 012-1; 9.5.3.1 pulse shape and amplitude (binary zero)-pulse shape.

Ensuring that a pulse complies with a pulse mask depends on three parameters, the rising and falling edge slopes, the width and the amplitude of the pulse. Figure 2A shows an ideal pulse 2, in which the rising and falling edge slopes are vertical. However, in practice, it is not possible to achieve this ideal pulse 2 and a typical actual pulse 5 output by a transmitter is shown in Figure 2B. As the actual pulse 5 never conforms exactly to the ideal pulse 2, a pulse mask provides a definition of the acceptable tolerances in an actual pulse 5. Figure 3 shows a schematic example of a pulse 8 which does not fit within a mask 9 defined by the lines in phantom. In this case there is a mask violation in the region 10 and the transmitting electronics will have to be modified to modify the profile of the pulse 8 to ensure that it fits within the mask 9.

For ISDN communication systems the transmitting electronics normally comprise a digital interface and control unit and an analogue line driver. Conventional solutions at overcoming the problems of mask violation have proposed increasing the line driver slew rate to make the rising and falling edge slopes of the pulse more vertical to ensure that the pulse fits within the mask.

However, this conventional approach for solving the problem of pulse mask compliance has the disadvantage of requiring increased power dissipation due to the higher current needed for the line driver to obtain the steeper rising and falling edge slopes. In addition, there is also the problem that steeper rising and falling edge slopes can cause increased electro-magnetic interference problems.

In accordance with a first aspect of the present invention, there is provided a method of modifying the profile of a pulse to fit a pulse mask, the method comprising modifying the width of the pulse so that the modified pulse fits the pulse mask.

Preferably, the only property of the pulse which is modified is the width of the pulse.

In accordance with a second aspect of the present invention, there is provided apparatus for modifying the profile of a pulse in a first input waveform of a digital data signal, the apparatus comprising first delay means having an input adapted to receive the first input waveform and an output to emit a first delayed waveform, the first delay means introducing a time delay to the first input waveform to generate the first delayed waveform; and a first selection means having a first input coupled to the output from the first delay means, a second input adapted to be coupled to the first input waveform and an output for emitting a first output waveform, and a first control means to control whether the first selection means couples the first input or the second input to the output.

Typically, the first input and the first output waveforms are substantially identical except for a difference in the width of the pulses.

Preferably, the delay means is adjustable to permit the delay introduced into the first input waveform to be increased or decreased.

Typically, the delay means receives a clock signal input, and the time delay that is introduced is an integral number of clock cycles. Typically, the frequency of the clock signals is at least a factor of ten greater than the frequency of the digital data signal.

Typically, the output waveform may be coupled to an analog line driver and provides a control input to control the output of the analog line driver.

Preferably, the digital data signal comprises a second input waveform, and the apparatus comprises a second delay means and a second selection means to output a second output waveform.

Preferably, the first control means is provided by the second input waveform and the second control means is provided by the first input waveform.

In one example of the invention, the selection means comprises a multiplexer.

Preferably, if the control signal to the selection means represents digital "1", the output from the selection means is digital "0" if either the first input waveform or the delayed waveform are digital "0".

Preferably, if the control signal represents digital "0", the output from the selection means is digital "1" if either the first input waveform or the delayed digital waveform are digital "1".

In one example of the invention, the selection means comprises a logical AND gate, a logical OR gate and a multiplexer, the logical AND gate having a first input coupled to the first input waveform, a second input coupled to the delayed waveform and an output coupled to a first input of the multiplexer, the logical OR gate having a first input coupled to the first input waveform, a second input coupled to the delayed waveform and an output coupled to a second input of the multiplexer, and the control signal controls the multiplexer to couple either the first input or the second input of the multiplexer to the output of the multiplexer.

Examples of a method of and an apparatus for modifying the profile of a pulse in a waveform in accordance with the invention will now be described with reference to the accompanying drawings, in which:
Figure 1 shows a pulse mask for European Telecommunication Standard prETS300 012-1;
Figure 2A is a schematic view of an ideal pulse;
Figure 2B is a schematic view of an actual pulse;
Figure 3 is a schematic view of a pulse mask with a pulse which violates the mask;
Figure 4 is a block diagram showing a digital interface and control unit and an analog line driver for transmitting digital data signals onto an ISDN communication line;
Figure 5 is a schematic block diagram showing a basic circuit for increasing the duration of a pulse;
Figure 6A and 6B show examples of an input pulse and an output pulse, respectively for the circuit shown in Figure 5;
Figure 7 illustrates the problem of pulse imbalance in the output from an analog line driver when a digital data signal changes from digital "01" to "10";
Figures 8 to 10 show possible methods of reducing pulse imbalance in accordance with the invention;
Figure 11 is a block diagram of a first example of a digital interface and control circuit in accordance with the invention; and
Figure 12 is a block diagram of a second digital interface and control circuit in accordance with the invention.

Figure 1 shows a pulse mask 1 for European telecommunication standard prETS 300 012-1 for Integrated Services Digital Network (ISDN); Basic User Network Interface (UNI). The pulse mask 1 is a requirement that any transmitting equipment must meet in order to conform to the standard. If any pulse transmitted by telecommunication equipment does not fit within the mask 1, then the equipment does not conform to this standard.

Figure 2A shows an ideal pulse 2. In the ideal pulse 2 the waveform changes state instantaneously between digital "0" and digital "1", so that the edges 3, 4 of the pulse are vertical, as shown in Figure 2A.

However, in practice, it is impossible to achieve an instantaneous transition, and in all practical applications the transmitting equipment produces an actual pulse 5 (see Figure 2B), in which the transition between digital "0" and digital "1" is not instantaneous. This results in the actual pulse 5 having non-vertical edges 6, 7. If the slope of the edges 6, 7 is not steep enough, the pulse 5 will not fit within the pulse mask. However, all pulse masks, permit a certain degree of tolerance in the angle of the edges 6, 7 from the vertical.

A schematic example of a pulse 8 violating a pulse mask 9 is shown in Figure 3, where it can be seen that pulse 8 violates the mask 9 in the region 10.

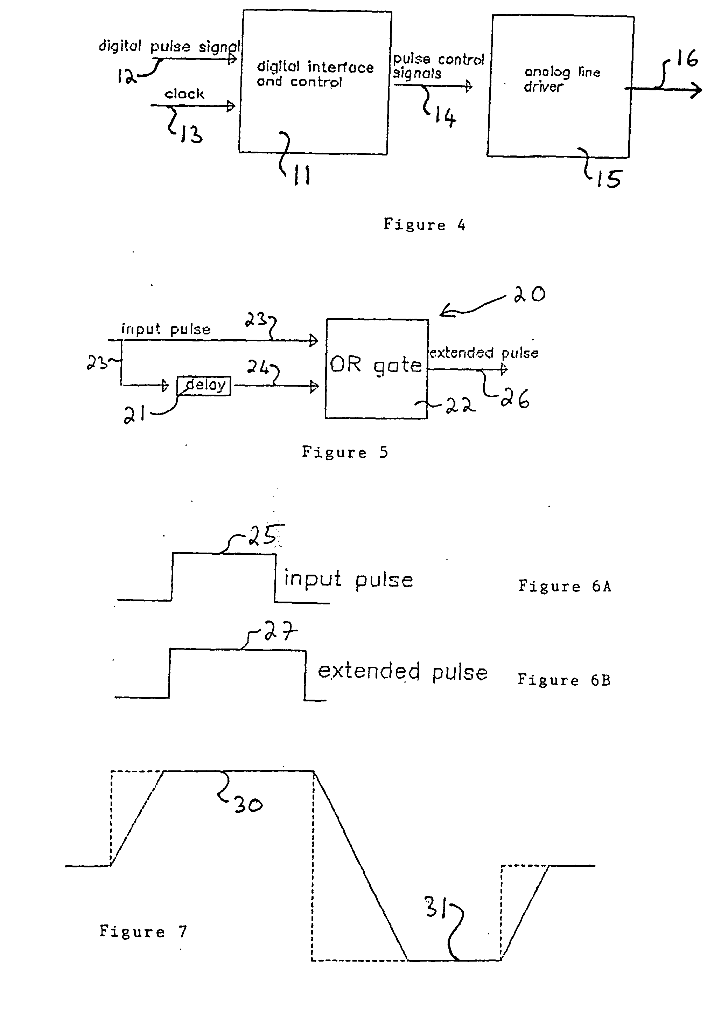

A typical telecommunication transmitting equipment is shown in Figure 4. The transmitting equipment includes a digital interface and control unit 11 which receives an input digital data signal 12 and a clock input signal 13. From the digital data signal 12 and the clock input signal 13, the digital interface and control unit 11 generates control signals 14 which control an analog line driver 15 which transmits the digital data signals on a telecommunication line 16.

Previous solutions at overcoming the problem of mask violation have concentrated on increasing the output power of the analog line driver 15 in order to increase the slope of the edges 6, 7. This is commonly known as increasing the slew rate of the line driver 15. However, this approach has the problem that it increases the power required to drive the analog line driver 15, which has the problem of requiring increased power dissipation from the analog line driver 15. In addition, it is also possible that the steeper edges may cause electro-magnetic interference problems.

In contrast to this, the inventor has realised that, provided that the analog line driver has a minimum slew rate, it is possible to modify the shape of a pulse to fit a pulse mask by modifying the duration (or width) of a pulse, instead of increasing the rising and falling edge slopes of the pulse. For example, in Figure 3, the pulse 8 can be modified to a modified pulse 8a (shown in phantom in Figure 3) by increasing the width of the pulse 8 without increasing the rising and falling edge slopes of the pulse 8. The modified pulse 8a fits within the pulse mask 9.

Figure 5 shows a basic circuit that can be used to increase a pulse width. The circuit 20 includes a delay means 21 and a logical OR gate 22. The delay means 21 receives an input waveform 23, generates a delay to the waveform and outputs a delayed waveform 24. The OR gate 22 receives the input waveform 23 and the delayed waveform 24, and produces an output waveform 26.

When an input pulse 25 (see Figure 6A) appears on the input waveform 23, the input waveform 23 rises to digital "1" and this is input to the OR gate 22 and to the delay means 21. Due to the delay introduced by the delay means 21 when the input waveform 23 rises to digital one, the delayed waveform 24 will remain at digital "0" for the delay time interval before also changing to digital "1". However, because of the OR gate 22, the output waveform 26 will change to digital "1" as soon as the input waveform 23 changes to digital "1". At the end of the input pulse 25, the input waveform 23 drops to digital "0". However, due to the time delay introduced by the delay means 21, the delayed waveform 24 will remain at digital "1". Hence, the output waveform 26 from the OR gate continues to be digital "1" until the delayed waveform 24 changes to digital "0". Hence, the circuit 20 receives an input pulse 25 and generates an extended output pulse 27 (see Figure 6B) on the output waveform 26.

Another problem that exists in conventional transmission equipment is that when two successive pulses of opposite polarity are transmitted, the slew rate of the line driver 15 causes an imbalance such that the area of the first pulse 30 is larger than the area of the second pulse 31. This is shown schematically in Figure 7. In addition, the lower the slew rate of the line driver 15, the greater the imbalance between the first and second pulses 30, 31. Hence, conventionally, it has been common practice to attempt to solve this problem also by increasing the slew rate of the line driver.

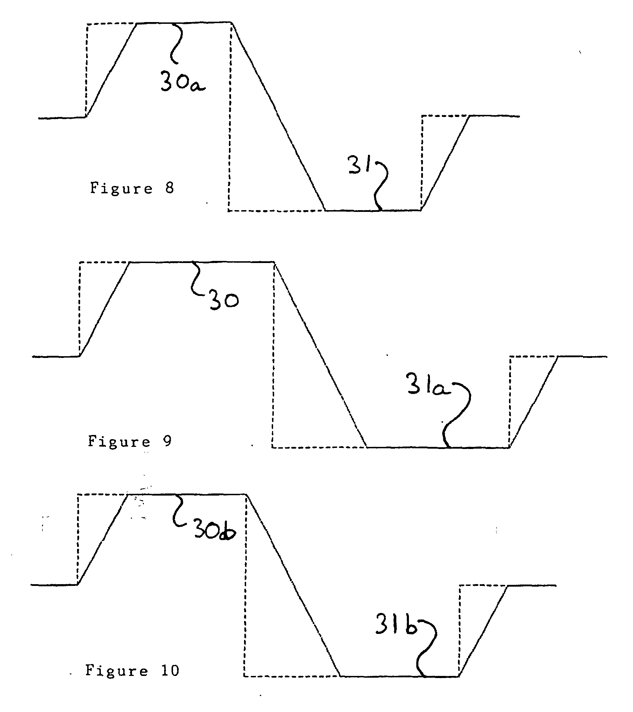

However, the inventor has also realised that by adjusting the duration (or width) of the pulses 30, 31 it is also possible to meet the ISDN layer 1 pulse unbalance specification of less than 5%, without requiring the line driver slew rate to be increased. For example, this can be done by reducing the width of the first pulse 30 to obtain a modified first pulse 30a; as shown in Figure 8; increasing the width of the second pulse 31 to obtain a modified second pulse 31 a, as shown in Figure 9; or a combination of decreasing the width of the first pulse to obtain a modified first pulse 30b and increasing the width of the second pulse to obtain a modified second pulse 31b, as shown in Figure 10.

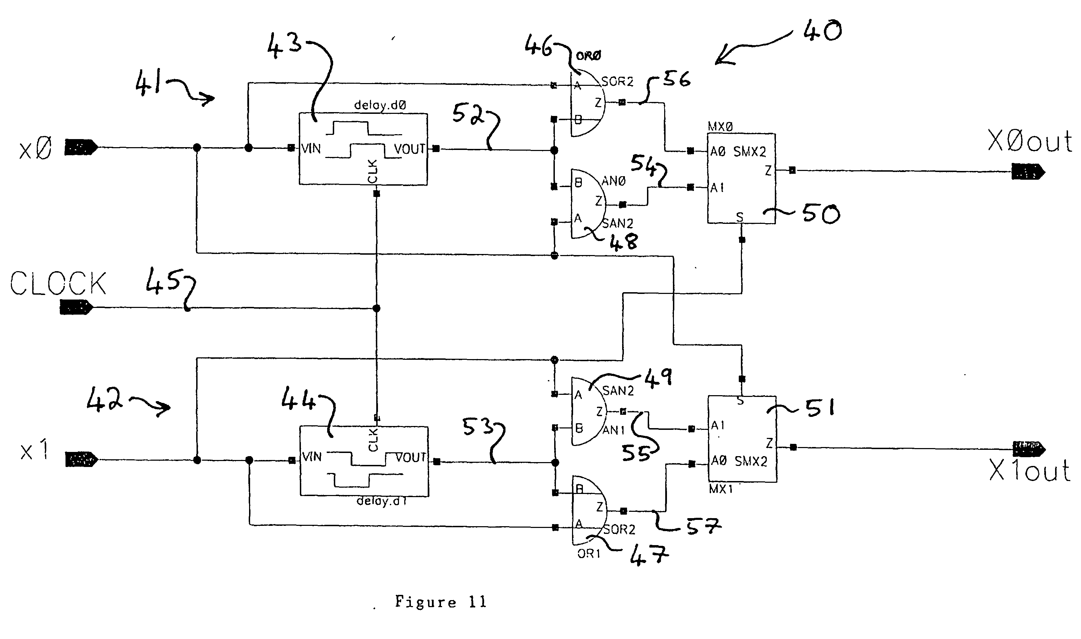

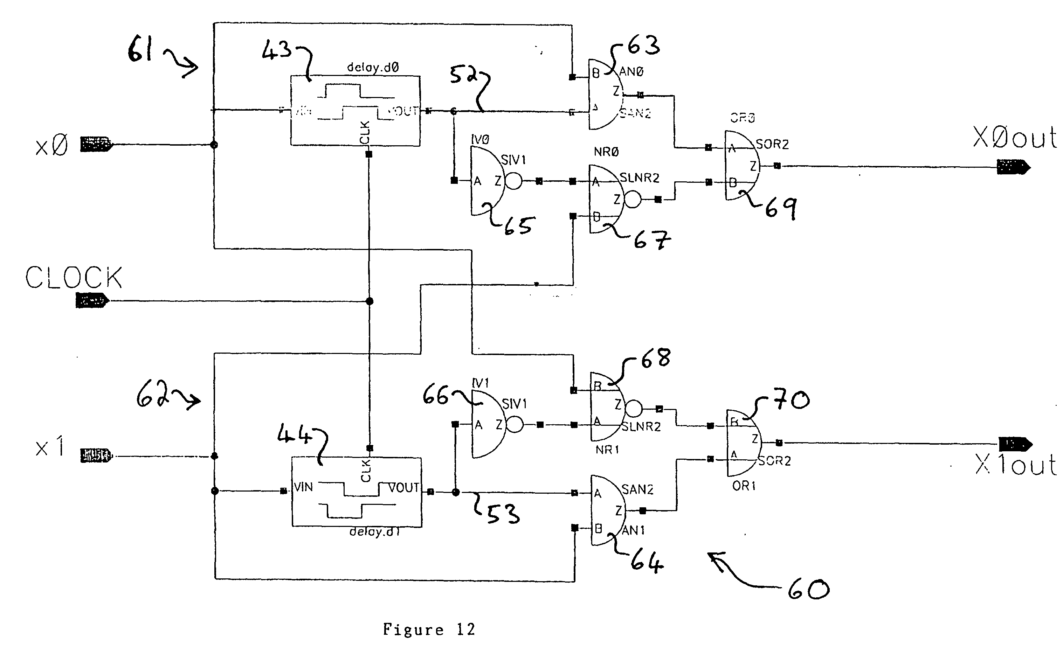

Figures 11 and 12 show two practical circuits 40, 60 for implementing the invention. The circuits 40, 60 are incorporated into the digital interface and control unit 11. In practice, an ISDN digital data signal comprises two waveforms x0, x1. Possible inputs are: x0 = 0, x1 = 0; x0 = 0, x1 = 1 (a positive pulse); and x0 = 1, x1 = 0 (a negative pulse). The permutation x0 = 1, x1 = 1 is an illegal permutation.

The circuit 40 receives an input digital data signal comprising two input waveforms x0, x1 and the circuit 40 includes two channels 41, 42. The channel 41 receives input waveform x0 and generates an output waveform X0out. The channel 42 receives the input waveform x1 and generates an output waveform X1out. Each channel 41, 42 includes a respective delay circuit 43, 44 which receives as inputs the respective input waveforms x0, x1 and a clock signal 45.

The input waveforms x0, x1 are also each fed to a respective logical OR gate 46, 47 and a logical AND gate 48, 49. In addition, the input waveform x0 is fed to a switch input of a multiplexer 51 in the channel 42 and the input waveform x1 is fed to a switch input of a multiplexer 50 in the channel 41.

The delay circuits 43, 44 generate delayed waveforms 52, 53 respectively and the delay in the delayed waveforms 52, 53 is dependent on the number of clock intervals set for the delay in the delay circuits 43, 44. Typically, the clock signal has a frequency in the region of 1 MHz to 20 MHz and for ISDN communications, the ideal pulse width is 5.21 µs which corresponds to a frequency of 0.192 MHz. Therefore, it is possible to use the clock signal to set the delay in the delay circuits 43, 44. Typically, the number of clock intervals that the delay circuits 43, 44 introduce as a delay into the input waveforms x0, x1 to generate the delayed waveforms 52, 53 respectively is adjustable, typically by some form of programming means.

The delayed waveforms 52, 53 are then fed to the respective OR gates 46, 47 and the respective AND gates 48, 49. Outputs 54, 55 from the AND gates 48, 49 are fed to the respective "1" pin of the multiplexers 50, 51. Outputs 56, 57 from the OR gates 46, 47 are fed to the "0" pins of the multiplexers 50, 51.

If both the input waveforms x0, x1 are zero and an input pulse appears on the input waveform x1, the output 57 from the OR gate 47 will change to digital "1". As x0 = 0, the multiplexer 51 will be switched to the "0" pin and so X1out changes to digital "1". At the end of the pulse, x1 changes to digital "0" but x0 still equals digital "0" and so the multiplexer 51 remains switched to the "0" pin. Although the input of the OR gate 47 which is connected directly to x1 changes to zero, the input of the OR gate 47 which is connected to the delay circuit 44 remains at digital "1" for the preset delay in the delay circuit 44 after the transition of x1 from digital "1" to digital "0". Therefore, after x1 changes to digital "0", the delayed waveform 53 remains at digital "1" and the OR gate 47 outputs digital "1" to pin "0" of the multiplexer 51. Hence, X1out still equals digital "1" even after x1 has changed back to zero. Therefore, the pulse in the input waveform x1 is modified by the circuit 40 so that the corresponding output pulse on the output waveform X1out has an increased width compared with the input pulse. The increase in the pulse width is equal to the number of clock intervals of delay set in the delay circuit 44.

If the digital input signal has two successive pulses of opposite polarity, this corresponds to a pulse on x1 immediately followed by a pulse on x0. In this case, the circuit 40 acts to reduce the imbalance by omitting the delay from the first pulse and adding a delay to the second pulse. For example, if the first pulse is on the input waveform x1 and the second pulse is on the input waveform x0, when x1 changes to digital "1", X1out will also change to digital "1", as described above. However, when x1 changes to digital "0" and x0 changes to digital "1" (the end of the first pulse and beginning of the second pulse), the switch input of the multiplexer 51 changes to the "1" pin so that the multiplexer transmits the output signal 55 from the AND gate 49. Although the delayed waveform 53 will still be digital "1" when x1 changes to digital "0", as the other input of the AND gate 49 changes to "0", the output signal 55 from the AND gate 49 also changes to "0" which means that X1out immediately becomes "0" when x1 changes to "0". Simultaneously, X0out will change to "1" as the switch input of the multiplexer 50 will be switched to the "0" pin of the multiplexer 50 when x1 changes to zero. Hence, X0out becomes "1". When x0 changes to "0", and assuming that x1 remains at "0" so that the multiplexer 50 continues to be connected to the "0" pin, the output X0out will continue to equal "1" after x0 changes to zero for a time interval equal to the preset delay introduced by the delay circuit 43 into the delayed waveform 52.

Therefore, the circuit 40 also reduces pulse imbalance between two successive pulses of opposite polarity by omitting the delay from the first pulse and adding a delay to the second pulse.

The circuit 60 is similar to the circuit 40 and also includes two channels 61, 62. The circuit 60 uses the same delay circuits 43, 44 to generate the delayed waveforms 52, 53 respectively. However, instead of using logical AND and OR gates coupled to a multiplexer, each of the channels 61, 62 uses an AND gate 63, 64 which receives the input waveforms x0, x1 respectively and the delayed waveforms 52, 53. In addition, the delayed waveforms 52, 53 are coupled to inverting gates 65, 66 respectively and the output from the inverting gates 65, 66 is coupled to an input of respective NOR gates 67, 68. Each NOR gate 67, 68 also receives as an input the input waveform x1, x0 from the respective other channel 62, 61. The AND gates 63, 64 and the NOR gates 67, 68 have their outputs coupled to respective OR gates 69, 70 which output the output waveforms X0out, X1out.

The circuit 60 operates in identical manner to the circuit 40 with the OR gates 46, 47, the AND gates 48, 49 and the multiplexers 50, 51 being replaced by the combination of the AND gates 63, 64, the inverting gates 65, 66, the NOR gates 67, 68 and the OR gates 69, 70.

The invention has the advantage that it permits a pulse on an input waveform x0, x1 to be modified to fit a pulse mask by changing the width of the pulse and without requiring the power of the line driver to be increased to increase the slew rate of the line driver.

In addition, the invention also has the advantage of reducing the imbalance between successive pulses of opposite polarity.

Furthermore, the invention has the advantage that it reduces the possibility of logic timing hazards and glitches in the transmitted digital data signals, as any glitch or hazard will be masked by the delay introduced by the delay circuits 43, 44, provided that the duration of the hazard or glitch is less than the duration of the delay introduced by the delay circuits 43, 44.

## Claims

1. A method of controlling an analog line driver (15) to transmit a digital data signal, the method including:
generating a pulse for transmission using the line driver (15) as part of the digital data signal,
modifying the profile of the pulse, the modification of the pulse comprising modifying the width of the pulse; and
transmitting the modified pulse to the line driver (15) as a control input to control the output of the analog line driver (15) so that the line driver output fits a pulse mask.

2. A method according to claim 1, wherein the only property of the pulse which is modified is the width of the pulse.

3. A method according to claim 1 or claim 2, wherein the width of the pulse is modified to increase the width of the pulse.

4. A method according to any of the preceding claims, wherein the width of the pulse is modified by feeding the input waveform to a delay means (21; 43,44) and to a selection means, the delay means (21; 43, 44) introducing a time delay into the waveform to generate a delayed waveform, feeding the delayed waveform to the selection means, and controlling the selection means to output the input waveform at the beginning of a pulse and to output the delayed waveform at the end of the pulse.

5. A method according to claim 4, wherein the selection means is controlled by another waveform in the digital data signal.

6. A method according to claim 4 or claim 5, wherein the time delay is generated by a clock signal (CLOCK) fed to the delay means (43, 44).

7. A method according to claim 6, wherein the time delay is an integral number of clock cycles.

8. A method according to any preceding claim in which the respective widths of two successive pulses of opposite polarity are modified, the method including one or both of:
(a) reducing the width of the first pulse; and
(b) increasing the width of the second pulse.

9. Apparatus for generating a digital data signal the apparatus comprising first delay means (43) having an input adapted to receive a first input waveform and an output to emit a first delayed waveform, the first delay means (43) introducing a time delay to the first input waveform to generate the first delayed waveform; and a first selection means (46, 48, 50; 63, 67, 69) having a first input coupled to the output from the first delay means (43), a second input adapted to be coupled to the first input waveform, an output for emitting a first output waveform, a control signal input to control whether the first input or the second input of the selection means is coupled to the output, and an analog line driver receiving the output and based on the output generating the digital data signal.

10. Apparatus according to claim 9, wherein the first delay means (43) is adjustable to permit the delay introduced into the waveform to be increased or decreased.

11. Apparatus according to claim 9 or claim 10, wherein the first delay means (43) receives a clock signal input (CLOCK), and the time delay that is introduced is an integral number of clock cycles.

12. Apparatus according to any of claims 9 to 11, wherein if the control signal to the selection means represents digital "1", the output from the selection means is digital "0" if either the first input waveform or the delayed waveform are digital "0".

13. Apparatus according to any of claims 9 to 12, wherein if the control signal to the selection means represents digital "0", the output from the selection means is digital "1" if either the first input waveform or the delayed waveform are digital "1".

14. Apparatus according to any of claims 9 to 13, wherein the digital data signal also comprises a second input waveform and the apparatus further comprises a second delay means (44) having an input adapted to receive the second input waveform and an output to emit a second delayed waveform, the second delay means introducing a time delay to the second input waveform to generate the second delayed waveform; and a second selection means (47, 49, 51; 64, 68, 70) having a first input coupled to the output from the second delay means, a second input adapted to be coupled to the second input waveform, an output for emitting a second output waveform, and a second control signal input to control whether the first input or the second input of the second selection means is coupled to the output.

15. Apparatus according to claim 14, wherein the first control signal input is adapted to be coupled to the second input waveform and the second control signal input is adapted to be coupled to the first input waveform.

## Patentansprüche

1. Verfahren zur Steuerung eines analogen Leitungstreibers (15) zum Aussenden eines digitalen Datensignals, wobei das Verfahren umfasst:
- Erzeugung eines Pulses zur Aussendung mittels des Leitungstreibers (15) als Teil des digitalen Datensignals,
- Modifizierung des Profils des Pulses, wobei die Modifikation des Pulses das Modifizieren der Weite des Pulses umfasst, und
- Übertragen des modifizierten Pulses zu dem Leitungstreiber (15) als ein Steuereingang, um den Ausgang des analogen Leitungstreibers (15) derart zu steuern, dass der Leitungstreiberausgang einer Pulsmaske entspricht.

2. Verfahren gemäß Anspruch 1, wobei die einzige Eigenschaft des Pulses, welche modifiziert wird, die Weite des Pulses ist.

3. Verfahren gemäß Anspruch 1 oder 2, wobei die Weite des Pulses modifiziert wird, um die Weite des Pulses zu vergrößern.

4. Verfahren gemäß einem der vorangegangenen Ansprüche, wobei die Weite des Pulses durch Zuführen der Eingangswellenform zu einem Verzögerungsmittel (21; 43, 44) und zu einem Auswahlmittel modifiziert wird, wobei das Verzögerungsmittel (21; 43, 44) eine Zeitverzögerung in die Wellenform einführt, um eine verzögerte Wellenform zu erzeugen, wobei die verzögerte Wellenform dem Auswahlmittel zugeführt wird und das Auswahlmittel gesteuert wird, um die Eingangswellenform zu Beginn eines Pulses und die verzögerte Wellenform an dem Ende des Pulses auszugeben.

5. Verfahren gemäß Anspruch 4, wobei das Auswahlmittel durch eine andere Wellenform in dem digitalen Datensignal gesteuert wird.

6. Verfahren gemäß Anspruch 4 oder 5, wobei die Zeitverzögerung durch ein dem Verzögerungsmittel (43, 44) zugeführtes Taktsignal (TAKT) erzeugt wird.

7. Verfahren gemäß Anspruch 6, wobei die Zeitverzögerung eine integrale Anzahl von Taktzyklen ist.

8. Verfahren gemäß einem der vorangegangenen Ansprüche, bei dem die jeweilige Weite von zwei aufeinanderfolgenden Pulsen gegensätzlicher Polarität modifiziert wird, wobei das Verfahren eines oder beides umfasst von:
a) Reduzierung der Weite des ersten Pulses, und
b) Vergrößerung der Weite des zweiten Pulses.

9. Vorrichtung zur Erzeugung eines digitalen Datensignals, die Vorrichtung umfassend erste Verzögerungsmittel (43) mit einem Eingang, ausgelegt um eine erste Eingangswellenform zu erhalten, und einem Ausgang, um eine erste verzögerte Wellenform auszusenden, wobei das erste Verzögerungsmittel (43) eine Zeitverzögerung in die erste Eingangswellenform einführt, um die erste verzögerte Wellenform zu erzeugen; und ein erstes Auswahlmittel (46, 48, 50; 63, 67, 69) mit einem ersten mit dem Ausgang des ersten Verzögerungsmittels (43) gekoppelten Eingang, einem zweiten Eingang, ausgelegt um mit der ersten Eingangswellenform gekoppelt zu sein, einem Ausgang zum Aussenden einer ersten Ausgangswellenform, einem Steuersignaleingang, um zu steuern, ob der erste Eingang oder der zweite Eingang des Auswahlmittels mit dem Ausgang gekoppelt ist, und einem analogen Leitungstreiber, der den Ausgang erhält und basierend auf dem Ausgang das digitale Datensignal erzeugt.

10. Vorrichtung gemäß Anspruch 9, wobei das erste Verzögerungsmittel (43) anpassbar ist, um zu erlauben, dass die in die Wellenform eingeführte Verzögerung vergrößert oder verkleinert wird.

11. Vorrichtung gemäß Anspruch 9 oder 10, wobei das erste Verzögerungsmittel (43) einen Taktsignaleingang (TAKT) erhält, und die Zeitverzögerung, die eingeführt ist, eine integrale Anzahl von Taktzyklen ist.

12. Vorrichtung gemäß einem der Ansprüche 9 bis 11, wobei, wenn das Steuersignal zu dem Auswahlmittel eine digitale "1" darstellt, der Ausgang des Auswahlmittels eine digitale "0" ist, wenn entweder die erste Eingangswellenform oder die verzögerte Wellenform eine digitale "0" ist.

13. Vorrichtung gemäß einem der Ansprüche 9 bis 12, wobei, wenn das Steuersignal zu dem Auswahlmittel eine digitale "0" darstellt, der Ausgang des Auswahlmittels eine digitale "1" ist, wenn entweder die erste Eingangswellenform oder die verzögerte Wellenform eine digitale "1" ist.

14. Vorrichtung gemäß einem der Ansprüche 9 bis 13, wobei das digitale Datensignal auch eine zweite Eingangswellenform umfasst und die Vorrichtung weiterhin umfasst ein zweites Verzögerungsmittel (44) mit einem Eingang, ausgelegt um die zweite Eingangswellenform zu erhalten, und einem Ausgang, um eine zweite verzögerte Wellenform auszusenden, wobei das zweite Verzögerungsmittel eine Zeitverzögerung in die zweite Eingangswellenform einführt, um die zweite verzögerte Wellenform zu erzeugen; und ein zweites Auswahlmittel (47, 49 51; 64, 68, 70) mit einem ersten mit dem Ausgang des zweiten Verzögerungsmittels gekoppelten Eingang, einem zweiten Eingang, ausgelegt um mit der zweiten Eingangswellenform gekoppelt zu sein, einem Ausgang zum Aussenden einer zweiten Ausgangswellenform, und einem zweiten Steuersignaleingang, um zu steuern, ob der erste Eingang oder der zweite Eingang des zweiten Auswahlmittels mit dem Ausgang gekoppelt ist.

15. Vorrichtung gemäß Anspruch 14, wobei der erste Steuersignaleingang ausgelegt ist, um mit der zweiten Eingangswellenform gekoppelt zu sein und der zweite Steuersignaleingang ausgelegt ist, um mit der ersten Eingangswellenform gekoppelt zu sein.

## Revendications

1. Procédé pour contrôler un module de commande de ligne analogique (15) afin de transmettre un signal de données numérique, le procédé comprenant les étapes consistant à :
générer une impulsion pour transmission en utilisant le module de commande de ligne (15) en tant que partie du signal de données numérique,
modifier le profil de l'impulsion, la modification de l'impulsion comprenant la modification de la largeur de l'impulsion ; et
transmettre l'impulsion modifiée au module de commande de ligne (15) en tant qu'entrée de contrôle afin de contrôler la sortie du module de commande de ligne analogique (15) de sorte que la sortie du module de commande de ligne s'ajuste à un masque d'impulsion.

2. Procédé selon la revendication 1, dans lequel la seule propriété de l'impulsion qui est modifiée est la largeur de l'impulsion.

3. Procédé selon la revendication 1 ou la revendication 2, dans lequel la largeur de l'impulsion est modifiée afin d'augmenter la largeur de l'impulsion.

4. Procédé selon l'une quelconque des revendications précédentes, dans lequel la largeur de l'impulsion est modifiée en alimentant la forme d'onde d'entrée à un moyen de retard (21 ; 43, 44) et à un moyen de sélection , le moyen de retard (21 ; 43, 44) introduisant un retard de temps dans la forme d'onde afin de générer une forme d'onde retardée, en alimentant la forme d'onde retardée au moyen de sélection et en contrôlant le moyen de sélection de façon à émettre en sortie la forme d'onde d'entrée au début d'une impulsion et d'émettre en sortie la forme d'onde retardée à la fin de l'impulsion.

5. Procédé selon la revendication 4, dans lequel le moyen de sélection est contrôlé par une autre forme d'onde dans le signal de données numérique.

6. Procédé selon la revendication 4 ou la revendication 5, dans lequel le retard de temps est généré par un signal d'horloge (CLOCK) alimenté au moyen de retard (43, 44).

7. Procédé selon la revendication 6, dans lequel le retard de temps est un nombre entier de cycles d'horloge.

8. Procédé selon l'une quelconque des revendications précédentes, dans lequel les largeurs respectives de deux impulsions successives de polarité opposée sont modifiées, le procédé comprenant l'une ou les deux étapes consistant à :
(a) réduire la largeur de la première impulsion ; et
(b) augmenter la largeur de la deuxième impulsion.

9. Appareil destiné à générer un signal de données numérique, l'appareil comprenant un premier moyen de retard (43) ayant une entrée adaptée à recevoir une première forme d'onde d'entrée et une sortie destinée à émettre une première forme d'onde retardée, le premier moyen de retard (43) introduisant un retard de temps à la première forme d'onde d'entrée afin de générer la première forme d'onde retardée ; et un premier moyen de sélection (46, 48, 50 ; 63, 67, 69) ayant une première entrée couplée à la sortie du premier moyen de retard (43), une deuxième entrée adaptée à être couplée à la première forme d'onde d'entrée, une sortie destinée à émettre une première forme d'onde de sortie, une entrée de signal de contrôle afin de contrôler si la première entrée ou la deuxième entrée du moyen de sélection est couplée à la sortie et un module de commande de ligne analogique recevant la sortie et basé sur la sortie générant le signal de données numérique.

10. Appareil selon la revendication 9, dans lequel le premier moyen de retard (43) est ajustable afin de permettre au retard introduit dans la forme d'onde d'être augmenté ou diminué.

11. Appareil selon la revendication 9 ou la revendication 10, dans lequel le premier moyen de retard (43) reçoit une entrée de signal d'horloge (CLOCK) et le retard de temps qui est introduit est un nombre entier de cycles d'horloge.

12. Appareil selon l'une quelconque des revendications 9 à 11, dans lequel si le signal de contrôle au moyen de sélection représente le « 1 » numérique, la sortie du moyen de sélection est le « 0 » numérique si l'un de la première forme d'onde d'entrée ou de la forme d'onde retardée représente le « 0 » numérique.

13. Appareil selon l'une quelconque des revendications 9 à 12, dans lequel si le signal de contrôle du moyen de sélection représente le « 0 » numérique, la sortie du moyen de sélection représente le « 1 » numérique si soit la première forme d'onde d'entrée soit la forme d'onde retardée représente le « 1 » numérique.

14. Appareil selon l'une quelconque des revendications 9 à 13, dans lequel le signal de données numérique comprend également une deuxième forme d'onde d'entrée et l'appareil comprend en outre un deuxième moyen de retard (44) ayant une entrée adaptée à recevoir la deuxième forme d'onde d'entrée et une sortie destinée à émettre une deuxième forme d'onde retardée, le deuxième moyen de retard introduisant un retard de temps à la deuxième forme d'onde d'entrée afin de générer la deuxième forme d'onde retardée ; et un deuxième moyen de sélection (47, 49, 51 ; 64, 68, 70) ayant une première entrée couplée à la sortie du deuxième moyen de retard, une deuxième entrée adaptée à être couplée à la deuxième forme d'onde d'entrée, une sortie destinée à émettre une deuxième forme d'onde de sortie et une deuxième entrée de signal de contrôle afin de contrôler si la première entrée ou la deuxième entrée du deuxième moyen de sélection est couplée à la sortie.

15. Appareil selon la revendication 14, dans lequel la première entrée de signal de contrôle est adaptée à être couplée à la deuxième forme d'onde d'entrée et la deuxième entrée de signal de contrôle est adaptée à être couplée à la première forme d'onde d'entrée.
